# EUROPÄISCHE PATENTSCHRIFT

(11) **EP 0 905 929 B1**
(45) Veröffentlichungstag und Bekanntmachung des Hinweises auf die Patenterteilung: **14.08.2013**
(21) Anmeldenummer: 98110279.1
(22) Anmeldetag: 05.06.1998
(51) Int. Cl.: H04H 20/22

(54) **Verfahren zur schnellen optimalen Auswahl der alternativen Frequenzen in einem Radiodatenempfänger**
Method for rapid optimal selection of alternative frequencies in a Radio Data System receiver
Méthode pour la sélection optimale et rapide de fréquences alternatives dans un récepteur RDS

(30) Priorität: 26.09.1997 DE 19742494
(43) Veröffentlichungstag der Anmeldung: 31.03.1999
(73) Patentinhaber: ROBERT BOSCH GMBH, 70442 Stuttgart (DE)
(72) Erfinder: Groeger, Klaus-Erwin, 31199 Diekholz (DE); Trinks, Rüdiger, 38704 Liebenburg (DE)

(56) Entgegenhaltungen:
- EP-A- 0 403 744
- EP-A- 0 415 132
- EP-A- 0 431 694
- EP-A- 0 443 436
- EP-A- 0 459 360
- EP-A- 0 476 826
- EP-A- 0 599 330
- EP-A- 0 768 756
- GB-A- 2 240 667
- US-A- 5 390 343

## Beschreibung

### Technisches Gebiet

Die Erfindung betrifft ein Verfahren zum Ablegen und Sortieren von Alternativfrequenzen in einem Alternativfrequenzspeicher eines RDS-Rundfunkempfängers gemäß dem Oberbegriff von Anspruch 1. Die Erfindung betrifft ferner einen RDS-Rundfunkempfänger mit PLL-Oszillator und Alternativfrequenzspeicher gemäß dem Oberbegriff von Anspruch 9.

### Stand der Technik

Ein sogen. RDS(Radio-Daten-System)-Signal dient bei drahtlosen Programmaustrahlungen, beispielsweise von Radioprogrammen für Reisende in einem Kraftfahrzeug, welches mit einem entsprechendem RDS-Autoradio ausgestattet ist, zur Übermittlung verschiedener wichtiger Informationen, mit denen das RDS-Autoradio u.a. eine Vielzahl von für einen ungestörten Empfang nötigen Operationen selbständig und automatisiert ausführt, ohne daß beispielsweise ein Fahrer seine Aufmerksamkeit vom Straßenverkehr abwenden und manuelle Eingaben am RDS-Autoradio durchführen muß.

Das RDS-Signal ist in der EBU-Spezifikation DIN EN50067 spezifiziert und enthält bzw. überträgt mit dem Sendersignal eines momentan am RDS-Autoradio eingestellten Rundfunksenders, nachfolgend auch Mutterfrequenz oder kurz MF genannt, beispielsweise eine Alternativfrequenz-Liste, welche Alternativfrequenzen (AF) des momentan eingestellten Rundfunksenders enthält. Diese AF sind Frequenzen von anderen Sendern, die zu einer Senderkette des momentan eingestellten Rundfunksenders/-Programms gehören. Beispielsweise alle Sender, welche das Rundfunkprogramm von NDR2 ausstrahlen.

Gemäß der EBU-Spezifikation DIN EN50067 werden diese AF entweder nach einer Methode A oder einer Methode B gesendet. Ge-mäß Methode A steht die Frequenz des momentan eingestellten Senders, beispielsweise 92.1 MHz für NDR2, am Anfang der Liste und es folgt eine Aufstellung aller möglichen AF für diesen Sender bzw. diese Senderkette, also beispielsweise NDR2. Bei supraregionalen Sendern kann diese Liste sehr lang sein (bis 25 AF) bzw. auch AF enthalten, welche an dem momentanen Standort des Empfängers kein Sendersignal oder sogar ein Sendersignal eines Senders mit einem andern Rundfunkprogramm aufweisen, hier beispielsweise WDR3, je nach Standort.

Gemäß Methode B werden Frequenzpaare angegeben, wenn die Anzahl der AF'en 25 übersteigt oder um Frequenzen zu kennzeichnen, die zeitweilig andere Programme übertragen oder zu anderen Regionen gehören. Wenn der momentan eingestellte Rundfunksender NDR2 mit der Frequenz 92.1 MHz ist, so beginnt die Alternativfrequenz-Liste nach Methode-B beispielsweise wie nachfolgend:

| | |
|---|---|
| 92.1 | 94.1 |
| 92.1 | 96.2 |
| 92.1 | 94.6 |
| ... | ... |
| usw. | |

Eine entsprechend bezüglich der MF aufsteigende oder fallende Anordnung der AF'en erlaubt die Unterscheidung zwischen Originalsendern und Nachbarsendern in der Alternativfrequenz-Liste des RDS-Signals des momentan eingestellten Senders. Ist F1 die MF und sind F2 und F3 AF'en, dann kennzeichnet eine Anordnung F1<F2 die AF F2 als eine AF zu F1 mit dem gleichen Programm und eine Anordnung F3>F1 kennzeichnet die AF F3 als eine AF einer regionalen Variante der MF F1. Hierbei sind Originalsender solche Rundfunksender, die exakt dasselbe Programm wie der momentan eingestellte Sender ausstrahlen. Nachbarsender sind solche, die zwar grundsätzlich dasselbe Rundfunkprogramm wie der momentan eingestellte Sender ausstrahlen, aber temporär, beispielsweise zu bestimmten Tageszeiten, ein regional unterschiedliches Programm haben. Nachbarsender gehören zur selben Senderkette und sind beispielsweise BR2-Sender mit Regionalprogramm für Franken und BR2-Sender mit Regionalprogramm für Oberbayern.

Zur Differenzierung der verschiedenen Rundfunksender mit entsprechend unterschiedlichen Senderketten enthält das RDS-Signal des momentan eingestellten Rundfunksenders zusätzlich ein Programmidentifikations-Codesignal, nachfolgend PI-Code oder kurz PI genannt. Dieses besteht gemäß der EBU-Spezifikation DIN EN50067 aus 4 Stellen, die auch 1. Nibbel bis 4. Nibbel genannt werden. Das 1. Nibbel kennzeichnet das Land, z.B. "D" für Deutschland oder "F" Frankreich. Das 2. Nibbel kennzeichnet, ob es sich um einen supraregionalen, nationalen oder regionalen Sender handelt. Dieser 2. Nibbel enthält also die Unterscheidung zwischen den obengenannten Original- und Nachbarsendern. Das 3. Nibbel kennzeichnet die Senderkette, z.B. "8" für NDR. Das 4. Nibbel unterscheidet das jeweilige Programm der Senderkette, z.B. NDR1, NDR2, NDR3, NDR 4 usw. der Senderkette des Norddeutschen Rundfunks NDR.

Bei schlechter Signal- bzw. Empfangsqualität führt das RDS-Autoradio automatisch einen Test für Alternativfrequenzen (AF-Test) durch und wechselt ggf. auf eine Alternativfrequenz, wenn sich dort eine bessere Signal- bzw. Empfangsqualität ergibt. Eine bessere Empfangsqualität ist beispielsweise, aber nicht notwendigerweise, durch eine höhere Feldstärke gegeben. Tatsächlich führen auch Effekte wie Mehrwege-(Multipath-)Empfang, Datenfehlerrate beim Empfang des RDS-Signals oder Nachbarkanalstörungen teilweise unabhängig von der Feldstärke des Empfangssignals zu Beeinträchtigungen der Empfangsqualität. Die beste Empfangsqualität ergibt sich dabei aus einer Summe aller Parameter, die die Empfangsqualität widerspiegeln, wie beispielsweise Feldstärke, Multipathempfang-Feldstärken, Datenfehlerrate, Nachbarkanalstörungen. Diese Summe wird unter ggf. variabler Gewichtung der verschiedenen Parameter gebildet und ergibt einen Wert, welcher ein Maß für die Empfangsqualität ist.

Diese Gewichtung ist beispielsweise länderspezifisch. So ist z.B. in Frankreich der Modulationshub und die Feldstärke sehr hoch, durch Multipath-Empfang jedoch das NF-Signal aber mit hohen Störungen behaftet, wohingegen das RDS-Signal mit geringer Datenfehlerrate sehr gut detektierbar ist. Hier bekommt beispielsweise die Datenfehlerrate ein niedrigeres Gewicht. Somit kann es vorkommen, daß eine AF, welche in der Gesamtwertung lediglich die drittstärkste Feldstärke des empfangenen Sendersignals aufweist, momentan die beste Empfangsqualität bietet. Nachfolgend bezeichnet "beste AF" diejenige zu dem PI-Code gehörende AF, welche für den momentan gewählten Sender die beste Empfangsqualität bietet.

Der RDS-Rundfunkempfänger verwaltet die ihm bekannten Alternativfrequenzen beispielsweise in absteigender Reihenfolge bezüglich des oben erläuterten Wertes für die Empfangsqualität nach unterschiedlichen Systemen, unter Berücksichtigung zusätzlicher Informationen, so daß bei Verschlechterung der Empfangsqualität des momentan eingestellten Senders möglichst immer auf eine qualitativ bessere AF gewechselt werden kann.

Hierbei ist ein wesentliches Kriterium, daß die AF dasselbe Programm ausstrahlt, wie der momentan eingestellte Rundfunksender, da ein Wechsel des Programms nicht erwünscht ist. Vielmehr soll trotz unterschiedlicher Standorte, beispielsweise eines RDS-Autoradios in einem fahrenden Kraftfahrzeug, solange wie irgend möglich das einmal vom Benutzer gewählte Programm einer Senderkette mit für den jeweiligen Standort des RDS-Rundfunkempfängers optimaler Qualität hörbar sein. Hierzu prüft der RDS-Rundfunkempfänger den PI-Code für eine bestimmte AF und vergleicht den erhaltenen PI-Code mit demjenigen des momentan eingestellten Senders. Ist diese Überprüfung erfolgt, so wird diese PI im Nachfolgenden als eine "geprüfte PI" bezeichnet. Stimmen die PI-Codes überein, so wird im Nachfolgenden von einer "gültigen AF" gesprochen. Stimmen die PI-Codes nicht überein, so wird im nachfolgenden von einer "verbotenen AF" gesprochen.

Beim Prüfen des PI-Codes muß der RDS-Rundfunkempfänger kurz von der momentan eingestellten Frequenz auf die zu prüfende bzw. neu einzumessende und zu bewertende AF wechseln. Um einen unerwünschten Lautstärkesprung bzw. kurzen Wechsel in dem vom RDS-Rundfunkempfänger über Lautsprecher abgegebenen Niederfrequenzsignal zu vermeiden, wird während der kurzen Umschaltung die Lautsprecherausgabe stumm geschaltet, was nachfolgend als "Muten" bezeichnet wird. Nach dem Muten wird, je nach Ergebnis der Prüfung des PI-Codes, entweder die neu bewertete AF in der Alternativfrequenz-Liste an eine Stelle entsprechend der Empfangsqualität zu den anderen in der Liste befindlichen Signalen einsortiert und die Lautsprecherausgabe auf der ursprünglichen Frequenz wieder freigegeben oder die AF verworfen und die Lautsprecherausgabe auf der ursprünglichen Frequenz wieder freigegeben oder auf der geprüften neuen AF die Lautsprecherausgabe wieder freigegeben.

Zusätzlich kann optional die Regionalisierung, d.h. der 2. Nibbel des PI-Codes ausgewertet werden oder nicht. Wenn der 2. Nibbel ausgewertet werden soll, spricht man von einem sogn. "Reg.-On-Mode". Dies hat den Vorteil, daß man nicht versehentlich in ein neues Regionalprogramm rutscht. Der Nachteil kann jedoch sein, daß nur sehr wenige AF zur Verfügung stehen und ggf. an einem ungünstigen Standort kein Frequenzwechsel zu einem besser empfangbaren Originalsender möglich ist. Der Empfang könnte hier vollständig abbrechen. Daher ist es in machen von Rundfunksendern schlecht versorgten Umgebungen notwendig, die Auswertung des 2. Nibbels abzuschalten, um wenigstens einen Sender der Programmkette weiterhin hören zu können, wenn auch mit regional ggf. unterschiedlichem Programm. Diese Betriebsart wird auch als "Reg.-Off-Mode" bezeichnet.

Wenn bei automatischen Suchläufen die Empfangsfrequenzen nach weiteren AF abgesucht werden, so dient ein Suchlauf-Stop-Signal, nachfolgend "SL-Stop" genannt, dazu festzustellen, ob die auf einer Frequenz detektierte Feldstärke einer Mittenabstimmung eines empfangenen Senders entspricht oder ob es sich um ein Empfangssignal eines von einem Nachbarkanal übersprechenden Senders handelt. "SL-Stop" bezeichnet somit einen Mittenabstimmungsdetektor. Das Signal "SL-Stop" wird nur abgegeben, wenn der empfangene Sender richtig abgestimmt ist. Dies verhindert ein Stoppen des automatischen Suchlaufes auf Frequenzen, die lediglich von Nachbarkanälen übersprechende Signale aufweisen. Wird nämlich während des Suchlaufes zwar auf einer Frequenz eine Empfangsfeldstärke registriert, jedoch beim Abfragen des SL-Stop-Signals dieses nicht registriert, so erfolgt kein Stop auf dieser Frequenz.

Folgende Systeme der Verwaltung der AF im RDS-Rundfunkempfänger sind aus der DE 40 39 117 C2, DE 41 06 161 C2 und EP 0 476 826 B1 bekannt:
- Die Alternativfrequenz-Liste enthält die AF'en der Senderliste des RDS-Signals des momentan eingestellten Rundfunksenders. Diese AF sind nach Feldstärke sortiert und es ergibt sich der Nachteil, daß bei sich schnell wechselnden Senderlandschaften dieses System oftmals nicht schnell genug reagieren kann und ggf. die AF mit der vermeintlich besten Feldstärke schon längst keinen Empfang mehr bietet oder anderen starken Störungen unterliegen, wie beispielsweise Übersprechen eines anderen Senders auf einem Nachbarkanal.
- Die Alternativfrequenz-Liste enthält nur AF deren Programmidentifikation (PI-Code) geprüft ist, d.h. die Programmketteninformation (Programmidentifikation bzw. PI-Code) der jeweiligen AF ist ausgewertet und wird bei positivem Ergebnis des Vergleiches des PI-Codes der geprüften AF mit dem PI-Code des momentan eingestellten Senders als "gültige AF" in die Liste aufgenommen. Somit besteht die Alternativfrequenz-Liste nur aus einer Teilmenge aller senderseitig im RDS-Signal mitgeteilten AF. Dieses System hat den Nachteil, daß es auf schnelle Wechsel in der Senderlandschaft nicht flexibel genug reagiert und ggf. AF verwirft, die kurze Zeit später aufgrund eines Standortwechsels schon wieder gültig wären.

Die Alternativfrequenz-Liste enthält alle AF, wobei deren Inhalte erst bei Qualitätseinbrüchen des momentan eingestellten Rundfunksenders auf das Vorhandensein einer besseren Alternative geprüft werden. Dieses System hat den Nachteil, daß oft eine lange Zeitspanne ohne Empfang eines Senders oder mit nur sehr schlechtem Empfang auftritt, bis die Suche nach einer besseren Alternative abgeschlossen ist.

Aus der EP 0 459 360 A2 ist ein RDS-Rundfunkempfänger mit einer Einrichtung zum Aufsuchen aktuell empfangswürdiger alternativer Frequenzen bekannt. RDS-Rundfunkempfänger mit nur einem Empfangsteil müssen bei Verschlechterung der Empfangsverhältnisse auf alternative Frequenzen zurückgreifen, deren Qualitätsbeurteilung im Zeitpunkt der Umschaltung nicht mehr aktuell ist. Um die vielfältigen Nachteile des Ein-Empfänger-Konzeptes zu umgehen, wird ein RDS-Rundfunkgerät mit zwei Empfangsteilen beschrieben, das mit Hilfe eines Hintergrundempfängers die Empfangsqualität alternativer Freqenzen fortlaufend überwacht und in einem Hintergrundspeicher empirisch eine nach Empfangsqualität geordnete Liste empfangswürdiger RDS-Frequenzen mit und ohne Verkehrsdurchsagen aus dem Aktionsgebiet des mobilen Empfängers aufbaut. Beim Empfang eines RDS-Rundfunkprogramms ohne Verkehrsnachrichten können Verkehrsdurchsagen auf anderen Frequenzen derselben Sendeanstalt automatisch eingeblendet werden.

Aus der EP 0 403 744 A2 ist ein RDS-Rundfunkempfänger mit empirisch wachsendem Speicherinhalt seiner Programmspeicher bekannt. Beim Rundfunkdatensystem (RDS) werden zusammen mit dem Rundfunkprogramm unhörbar digitale Daten übertragen, die u.a. eine Liste alternativer Frequenzen (AF) mit gleichem Programm enthalten, aus denen der Empfänger eine andere Empfangsfrequenz auswählen kann, wenn sich durch Ortswechsel die Empfangsverhältnisse verschlechtern. Die Übertragung einer vollständigen AF-Liste vom Sender zum Empfänger kann jedoch bis zu 45 Sekunden und länger dauern. Um bei einem spontanen Programmabruf in unterschiedlichen Sendegebieten möglichst verzögerungsfrei und unhörbar auf alternative Frequenzen umschalten zu können, wenn die gespeicherte Frequenz des Muttersenders nicht empfangswürdig ist, sollen die Programmspeicher des Empfängers sofort eine begrenzte Auswahl geeigneter AFs zur Verfügung stellen. Der Speicherinhalt dieser Programmspeicher wird zu diesem Zweck empirisch aufgebaut, indem alternative Frequenzen der unter gleichem PI-Code ausgestrahlten Programme im Laufe e der Zeit aus anderen Speichern und/oder Speicherebenen automatisch in die Programmspeicher übernommen werden, wenn die bei einer betriebs- oder routinemäßigen Abstimmung des Empfängers empfangenen Frequenzen als RDS-Senderfrequenzen mit ausreichender Empfangsqualität bestätigt werden.

Die EP 0 415 132 A2 zeigt einen RDS-Rundfunkempfänger mit einer Einrichtung zum automatischen Wechsel auf ein alternatives Regionalprogramm. Im Radiodatensystem weisen sich Sendestationen mit gleichem Programm durch die Übertragung desselben PI-Codes aus. Wird das Programm innerhalb einer Programmkette zu bestimmten Tageszeiten regionalisiert, so sollte der PI-Code umgeschaltet werden. Es gibt jedoch Sendeanstalten, die grundsätzlich einen regionalisierten PI-Code ausstrahlen, auch wenn sie über die einzelnen Sendestationen zeitweise ein gemeinsames Rahmenprogramm übertragen. Um ein zusätzliches Bedienungselement am RDS-Empfänger zu vermeiden, das zu Fehlbedienungen führen kann, wird ein mobiles RDS-Empfangsgerät vorgestellt, bei dem bei Verlust einer regionalen Programmkette die aus früheren Empfangsroutinen gespeicherten alternativen Frequenzen daraufhin untersucht werden, ob ein anderes Regionalprogramm derselben Sendeanstalt empfangen werden kann, das dann bevorzugt eingestellt und als Teil einer neuen Programmkette akzeptiert wird.

### Darstellung der Erfindung, Aufgabe, Lösung, Vorteile

Es ist Aufgabe der vorliegenden Erfindung, ein verbessertes Verfahren bzw. einen verbesserten RDS-Rundfunkempfänger der obengenannten Art zur Verfügung zu stellen, welche die obengenannten Nachteile beseitigen und eine funktionsorientierte Speicherorganisation für bezüglich der Empfangsqualität bewertete RDS-Alternativfrequenzen als Vorbereitung für schnelle Frequenzwechsel bei Unterschreiten spezifischer Qualitätskriterien des eingestellten Rundfunksenders erlaubt.

Diese Aufgabe wird durch ein in Anspruch 1 angegebenes Verfahren und durch einen RDS-Rundfunkempfänger der o.g. Art mit den in Anspruch 9 gekennzeichneten Merkmalen gelöst.

Dazu ist es erfindungsgemäß vorgesehen, daß die Alternativfrequenzen (AF) sowohl einer Alternativfrequenz-Liste eines RDS-Signal eines momentan eingestellten Rundfunksenders als auch aus einer langzeitgespeicherten Liste unter der Programmidentifikation (PI) des eingestellten Rundfunksenders als auch aus einem Landschaftsspeicher, der die Alternativfrequenz (AF) mit zum momentan eingestellten Rundfunksender identischer, d.h. gültiger Programmidentifikation (PI) enthält und die z.Zt. empfangbaren Frequenzen im FM-Band wiederspiegelt, entnommen werden, daß zu jeder unter einer bestimmten Programmidentifikation (PI) gespeicherten Alternativfrequenz (AF) wenigstens ein zusätzliches Kennzeichen gespeichert wird, und daß das oder die zusätzlichen Kennzeichen als Sortierkriterium der Alternativfrequenzen (AF) im Alternativfrequenzspeicher verwendet werden.

Dies hat den Vorteil, daß eine langfristige Vorbereitung und Beobachtung der Qualitätsentwicklung von möglichen AF'en im Moment des Frequenzwechsels einen schnellen, sofortigen und zuverlässigen Sprung auf eine auch in diesem Moment noch brauchbare AF ermöglicht. Die Pflege des AF-Speichers aus unterschiedlichen Quellen hält auch bei Abschattungen oder neuen Senderlandschaften immer und zuverlässig die richtige AF bereit. Die momentane Empfangslandschaft bezüglich Programm- und Senderketten wird direkt im AF-Speicher abgebildet.

Vorzugsweise Weitergestaltungen des Verfahrens sind in den Ansprüchen 2 bis 8 beschrieben.

Eine besonders bevorzugte Ausführungsform ist dabei dadurch gekennzeichnet, daß das wenigstens eine zusätzliche Kennzeichen ein erstes zusätzliches Kennzeichen ist, welches angibt, ob die Alternativfrequenz (AF) zu einem Original- oder Nachbarbereichs-Sender gehört, und/oder ein zweites zusätzliches Kennzeichen ist, welches angibt, ob in der unmittelbaren Vergangenheit die Programmidentifikation (PI) dieser Alternativfrequenz (AF) bestätigt wurde, und/oder ein drittes zusätzliches Kennzeichen ist, welches angibt, ob eine vorübergehend verbotene Alternativfrequenz (AF), d.h. beispielsweise eine unklare bzw. noch nicht als richtig oder falsch erkennbare AF, für eine Neubewertung freigegeben ist, und/oder ein viertes zusätzliches Kennzeichen ist, welches angibt, wie stark bzw. mit welcher Qualität die Alternativfrequenz (AF) bei ihrer letzten Messung bewertet wurde, und/oder ein fünftes zusätzliches Kennzeichen ist, welches angibt, ob die AF derzeit als derzeit verbotene AF gekennzeichnet ist.

Das fünfte zusätzliche Kennzeichen gibt die Information, daß nach eindeutig falsch erkannter PI diese AF nicht angesprungen werden darf. Ferner werden solche AF'en von der ständigen Überprüfung und Neubewertung durch kurzes Anspringen und Auswerten des RDS-Signals ausgenommen, da dies nur sinnlos Zeit verschwenden würde. Eine derartige Situation ist aber in der Regel nur regional vorhanden und mit fortschreitender Reise bzw. mit der Bewegung des RDS-Rundfunkempfängers in einen anderen regionalen Bereich kann die Kennzeichnung dieser AF als derzeit verbotene AF durch eine entsprechend neue Senderlandschaft überholt sein. Aus diesem Grunde ist das dritte zusätzliche Kennzeichen vorgesehen, welches erlaubt, daß eine als derzeit verboten gekennzeichnete AF doch wieder für die Überprüfung und Neubewertung zugelassen wird. Solange jedoch die Überprüfung und Neubewertung weiterhin eine falsche PI ergibt, bleibt die Kennzeichnung im fünften Kennzeichen als "derzeit verbotene AF" bestehen. Sobald jedoch eine Überprüfung und Neubewertung eine richtige PI ergibt, wird das im fünften Kennzeichen gespeicherter Verbot wieder aufgehoben und diese AF wieder zu einer gültigen AF.

Das zweite zusätzliche Merkmal hat den Vorteil, daß auf Informationen aus der nahen Vergangenheit zurückgegriffen werden kann und diese Information nicht neu durch entsprechendes Muten und Prüfen des PI-Codes eingemessen werden muß. Hierbei war die neue im Moment wegen einer besseren zu erwartenden Empfangsqualität anzuspringende und zu prüfende AF vor kurzer Zeit bereits schon einmal eine momentan eingestellte AF und es ist bereits die Information im zweiten Kennzeichen gespeichert, daß diese AF eine gültige AF mit überprüftem PI-Code ist. Vor dem Wechsel auf diese AF ist somit kein Muten und Prüfen des PI-Codes notwendig, wenn das zweite Kennzeichen mitteilt, daß der PI-Code dieser AF vor kurzem erst bestätigt, d.h. diese AF als gültige AF bezüglich des momentan eingestellten Rundfunksenders bestätigt wurde. Vielmehr springt der RDS-Rundfunkempfänger diese neue AF in diesem Falle direkt an ohne zu Muten.

Es wird eine zusätzliche Aktualisierung der AF-Liste dadurch erzielt, daß die Alternativfrequenzen zusätzlich aus aktuell in Suchläufen erkannten AF hinzugefügt werden und optional ferner jede AF in einem vorbestimmten Rhythmus durch zeitlich kurze, im wesentlichen nicht wahrnehmbare Messungen von SL-Stop, Feldstärke und Qualität neu bewertet wird. Sender ohne SL-Stop werden dabei vorzugsweise mit niedrigstem Wert bzw. mit niedrigster Priorität gekennzeichnet, so daß sie in der AF-Liste ganz am Ende bei den AF stehen, welche zuletzt als AF herangezogen werden. Hierbei kann der Rhythmus in seiner Periodizität gezielt schwanken.

Eine geeignete Bewertung und Sortierung der AF wird dadurch erzielt, daß die AF gemäß allen ihren Meßwerten und zusätzlichen Kennzeichen sortiert werden, wobei die beste AF an die erste Stelle sortiert wird, um bei einem erforderlichen Sprungversuch als aussichtsreichste AF zur Verfügung zu stehen.

Für ein schnelles und verzögerungsfreies Wechseln zu einer AF auch bei allgemein schlechten Empfangsbedingungen wird das Verfahren bevorzugt in einem Reg.-Off-Mode ausgeführt, wobei die Kennzeichnung Original- bzw. Nachbarsender ohne Berücksichtigung bleibt.

Eine Listenpflege mit bevorzugter Behandlung von senderseitig als Original gekennzeichneter AF wird dadurch erzielt, daß das Verfahren in einem Reg.-On-Mode ausgeführt wird, wobei die Originalsender vor den Nachbarsendern einsortiert und damit bevorzugt werden. Dies berücksichtigt Original- und Nachbarbereichssendefrequenzen für die Auswahl der besten AF.

Eine immer aktuelle AF-Liste mit optimaler Bewertung der zu erwartenden Empfangsqualität wird dadurch erzielt, daß die Einmessung der AF ständig oder in Abhängigkeit von bestimmten Qualitätsschwellen des momentan eingestellten Rundfunksenders erfolgt.

Zweckmäßigerweise erfolgt die Einmessung der AF'en zusätzlich immer bei Eintreffen neuer, unbekannter AF'en.

In einer besonders vorteilhaften Weiterbildung der Erfindung wird jede Alternativfrequenz in einem vorbestimmten, vorzugsweise variierenden Rhythmus durch zeitlich kurze, im wesentlichen nicht wahrnehmbare Messungen von SL-Stop, Feldstärke und Qualität neu bewertet.

Bei einem RDS-Rundfunkempfänger der o.g. Art ist der PLL (phase-locked-loop) - Oszillator erfindungsgemäß ein schneller FPLL und der Alternativfrequenzspeicher für jede Alternativfrequenz weist wenigstens einen zusätzlichen Speicherplatz auf zum Speichern von einem ersten zusätzlichen Kennzeichen, welches angibt, ob die AF zu einem Original- oder Nachbarbereichs-Sender gehört, einem zweiten zusätzlichen Kennzeichen, welches angibt, ob in der unmittelbaren Vergangenheit die PI dieser AF bestätigt wurde, einem dritten zusätzlichen Kennzeichen, welches angibt, ob eine vorübergehend verbotene AF für eine Neubewertung freigegeben ist, einem vierten zusätzlichen Kennzeichen, welches angibt, wie stark bzw. mit welcher Qualität die AF bei ihrer letzten Messung bewertet wurde, und/oder einem fünften zusätzlichen Kennzeichen, welches angibt, ob die AF derzeit als verbotene AF gekennzeichnet ist.

Dies hat den Vorteil, daß eine langfristige Vorbereitung und Beobachtung der Qualitätsentwicklung von möglichen AF im Moment des Frequenzwechsels einen schnellen und zuverlässigen Sprung auf eine auch in diesem Moment noch brauchbare AF ermöglicht. Die momentane Empfangslandschaft bezüglich Programm- und Senderketten wird direkt im AF-Speicher abgebildet.

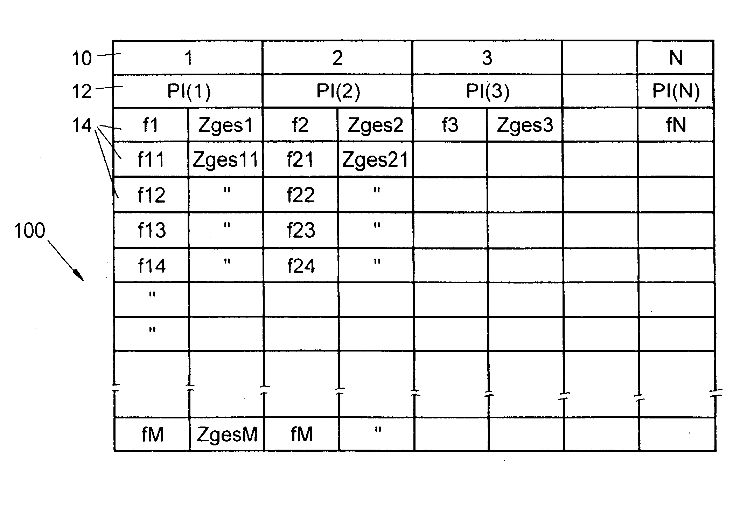

### Kurze Beschreibung der Zeichnung

Nachfolgend wird die Erfindung unter Bezugnahme auf die Figur näher erläutert. Diese zeigt in einer schematischen Darstellung eine bevorzugte Ausführungsform eines Alternativfrequenzspeichers eines erfindungsgemäßen RDS-Rundfunkempfängers.

### Bester Weg zur Ausführung der Erfindung

Die in der Figur dargestellte Ausführungsform eines Alternativfrequenzspeichers 100 eines erfindungsgemäßen RDS-Rundfunkempfängers umfaßt 1 bis N Speicher 10 für Alternativfrequenzen. Jeder Speicher 10 hat einen Speicherplatz 12 für einen Wert der Programmidentifikation PI(n) der jeweiligen n-ten gespeichert Alternativfrequenz, ggf. mehrere weitere, nicht näher dargestellte Speicherplätze für weitere Werte und einen Speicherplatz 14 für die Frequenz f(n) (f1, f11, f12, f13...f1M; f2, f21, f22, f23...f2M; ... fN, fN1, fN2, fN3...fNM) der jeweiligen n-ten gespeichert Alternativfrequenz. Weiter Speicherplätze beinhalten zusätzliche Kennzeichen Zges(n) (Z_{ges1}, Z_{ges11}···Z_{ges1M}; Z_{ges2}, Z_{ges21}···Z_{ges2M};··· Z_{gesN,} Z_{gesN1}···Z_{gesNM}), welche sich jeweils aus zusätzlichen Kennzeichen Z1(n), Z2(n), Z3(n), Z4(n) und/oder Z5(n) der jeweiligen n-ten gespeichert Alternativfrequenz zusammensetzen. Hierbei ergibt sich beispielsweise Z_{ges1} aus {Z1(1) Z2(1) Z3(1) Z4(1) Z5(1)}.

Bevorzugte Bestandteile eines erfindungsgemäßen RDS-Rundfunkempfängers sind ein schneller PLL-Oszillator, im nachfolgenden FPLL genannt, mit einer Sprungzeit von ca. 1ms, eine Speicherorganisation für mobile RDS-Empfangsgeräte, wie z.B. Autoradios, und ein Bewertungs- und Kategorisierungs-Verfahren für Alternativfrequenzen (AF) welches sicherstellt, daß die beste AF an erster Position im Speicher steht.

Der AF-Speicher, im nachfolgenden AFSTOR genannt, dient zur Aufnahme von AF aus verschiedenen Quellen und aufgrund des FPLL ist die Möglichkeit zur kontinuierlichen Qualitätsbewertung der AF ggf. mit Berücksichtigung der Original- und/oder Nachbarfrequenzkennung und Programmidentifikation (PI) -Prüfstatus gegeben.

In nahezu ganz Europa werden die AF beispielsweise nach der Methode B gesendet. Hierbei macht eine steigende Anordnung (AF1<AF2) bzw. eine fallende Anordnung (AF1>AF2) erkennbar, ob die genannte AF das Originalprogramm oder ein Nachbarprogramm überträgt. Dies ist eine Hilfestellung zur Vorsortierung bei regionalisierten Programmen mit unterschiedlichem PI im 2. Nibbel bzw. mit zeitweise unterschiedlichem PI. Selbst bei nicht regionalisiertem Programm gibt die steigende/fallende Folge Auskunft darüber, ob die genannte AF eine von der momentan eingestellten Frequenz, nachfolgend auch Mutterfrequenz (MF) genannt, unmittelbar benachbarte AF oder eine mit größerer Entfernung ist und nicht an das Empfangsgebiet der MF anschließt.

Durch den FPLL sind die Bewertungstests (Überprüfung und Neubewertung einer AF) unhörbar. Dies wird durch folgende Spezifikation des FPLL erreicht: Der Phasendetektor erlaubt einen Bandgrenzensprung (87,6 MHz bis 107,9 MHz) in 1,5 ms. Es ist eine Zeitkonstantenumschaltung für schnelles Einschwingen der Parameter Feldstärke und SL-Stop vorgesehen. Es ist eine Ruhestromschaltung bei automatischem LOCK-IN in üblicher Weise vorgesehen. Es erfolgt eine hörgerechte Muteschaltung, wie nachfolgend noch näher beschrieben wird.

Alle Aktivitäten zur Abstimmung auf die jeweils beste AF basieren auf der Bewertung aller verfügbaren AF im AF-Speicher. Der AF-Speicher AFSTOR beinhaltet dazu Informationen unterschiedlicher Quellen:
a. AF aus den über das RDS-Signal des Sendersignals selektierten AF-Listen des eingestellten Senders und
b. AF aus dem Langzeitgedächtnis unter dem gültigen PI des eingestellten Senders sowie
c. AF mit gültigem PI aus einem Speicher, der die z.Zt.
   empfangbaren Frequenzen im FM-Band wiederspiegelt (Landschaftsspeicher) und ggf. Ergänzungen durch Frequenzen die durch Suchläufe aktuell hinzugefügt (erkannt) werden.

Die Zusammenfügung und Pflege dieser drei AF-Quellen machen optimale Frequenzsprünge zu einer bessern AF weitgehend unabhängig von Empfangssituationen, in denen über das RDS-Signal des gerade eingestellten Rundfunksenders keine AF-Listen mehr empfangbar sind. Die ständige Pflege dieser Listen und die Berücksichtigung einer Original- und Nachbarfrequenzkennung sorgt auch bei langen AF-Listen für ein schnelles Auffinden von der stärksten, gültigen AF bzw. Folgefrequenz.

Dazu ist es erforderlich, daß die AF ständig einer Qualitätsbewertung unterzogen werden, so daß die Reihenfolge der AF im Speicher die Sendelandschaft (Empfangslandschaft) wiederspiegelt. Jede im AFSTOR unter einem bestimmten PI eingetragene Frequenz erhält zur Bewertung und Sortierung zusätzliche Kennzeichnungen, die folgende Inhalte haben:
a. Ein Kennzeichen, ob die AF ein Original- oder ein Nachbarbereichs-Sender ist gemäß eines Listenübertragungsverfahren, wie die obenerwähnte Methode B oder durch Auswerten des 2. Nibbels des PI-Code-Signals im RDS-Signals.
b. Ein Kennzeichen, ob in der unmittelbaren Vergangenheit die PI dieser AF als "gültige AF", d.h. mit derjenigen PI des momentan eingestellten Senders, bestätigt wurde. Dies ist dann der Fall, wenn die gerade zur Prüfung anstehende AF kurze Zeit vorher, beispielsweise einige Minuten bis Stunden bei gleichbleibender Qualität, bereits eine temporär eingestellte AF war. Zu diesem Zwecke mußte sie vorher bereits auf ihr PI-Code-Signal geprüft werden, welches als "gültige PI" erkannt wurde, sonst wäre diese AF nicht als momentan eingestellte AF zugelassen worden. Diese Information ist in diesem Kennzeichen gespeichert, so daß bei einem erneuten Anspringen dieser AF auf eine erneute Prüfung des PI-Codes verzichtet werden kann und diese AF mit der entsprechenden Information in diesem Kennzeichen für eine "gültige PI" sofort und ohne Muten für eine Prüfung des PI-Codes angesprungen wird. Der Benutzer erhält den Eindruck eines Unterbrechungsfreien Empfangs seines Lieblingsprogrammes und bemerkt nichts von dem Frequenzwechsel.
c. Ein Kennzeichen, ob eine vorübergehend verbotene AF (falsche PI) für eine Neubewertung freigegeben ist. Wie oben erwähnt, kann eine mit dem RDS-Signal empfangene Alternativfrequenz-Liste auch eine oder mehrere AF enthalten, die an dem momentanen Standort des RDS-Rundfunkempfängers ein Sendersignal mit einem anderen PI-Code aufweisen, als die Mutterfrequenz. Ist dies der Fall, so wird diese AF mit einem Eintrag in einem nachfolgend unter Punkt "e." erläuterten Kennzeichen als verbotene AF gekennzeichnet. Dadurch wird diese AF nicht ständig auf eine eventuelle Änderung der Empfangsqualität geprüft, da sie ohnehin wegen eines anderen Programms als desjenigen der Mutterfrequenz nicht als gültige AF in Frage kommt. Mit der Zeit ändert sich jedoch der Standort des RDS-Rundfunkempfängers und die Situation auf dieser AF kann sich dahingehend ändern, daß inzwischen möglicherweise der "falsche Sender" verschwunden ist und tatsächlich ein Sender mit "gültiger PI" empfangen wird (beispielsweise Überreichweiten). Um dies zu berücksichtigen wird nach vorbestimmten Bedingungen das Prüfverbot durch einen Eintrag in dieses Kennzeichen für diese AF aufgehoben, so daß wieder eine Prüfung der PI und Einmessung der für die Neubewertung der Empfangsqualität relevanten Parameter, wie beispielsweise SL-Stop und Feldstärke, erfolgt. Ggf. wird bei "gültiger PI" dann das unter "e." erläuterte Kennzeichen entsprechend geändert, wenn eine "gültige PI" registriert wird. Dieses Kennzeichen gibt also an, ob eine Freigabebedingung eingetreten ist. Eine "vorbestimmte Bedingung" könnte beispielsweise ein Zeitablauf sein oder eine Empfangsqualität einer momentan eingestellten MF oder AF wird sehr schlecht und danach wieder gut. Dies zeigt beispielsweise an, daß sich der RDS-Rundfunkempfänger in einer neuen Empfangsgegend befindet, in der sich das neue Einmessen (Überprüfen und Neubewerten) bisher verbotener AF wieder lohnen könnte.
d. Ein Kennzeichnung, wie stark, bzw. mit welcher Qualität die AF bei ihrer letzten Messung bewertet wurde. Dies ergibt in vorteilhafter Weise ein wesentliches Sortierkriterium für die AF im AFSTOR.
e. Ein Kennzeichen, ob Verbote oder Einschränkungen aus einer Langzeitbetrachtung vorliegen. In diesem Kennzeichen werden für den unter "c." geschildert Fall Merkmale eingetragen, die diese AF als verbotene oder unklare AF kennzeichnen, beispielsweise bei mehrfacher Registrierung eines falschen PI-Codes bezüglich des momentan eingestellten Senders, obwohl beispielsweise laut Alternativfrequenz-Liste aus dem RDS-Signal des momentan eingestellten Senders diese AF eine Alternativfrequenz mit gültigem PI sein müßte, oder auf der AF wird ein NICHT-RDS-Sender erkannt.

Durch eine ständige, unhörbaren Bewertung aller z.Zt. nicht auf die Lautsprecher geschalteten (nicht gehörten) AF findet eine kontinuierliche Bestimmung der Empfangsqualität der jeweiligen AF statt und daraufhin findet eine entsprechende Sortierung der AF-Reihenfolge im AFSTOR statt.

Die dadurch entstehende Dynamik des AFSTOR ist dergestalt, daß:
- in einem Rhythmus, dessen Periodizität gezielt schwanken kann, jede AF einer Neubewertung durch zeitlich sehr kurze, weitgehend nicht wahrnehmbare Messungen von SL-Stop, Feldstärke und Qualität unterzogen wird,
- die AF gemäß ihren Meßwerten sortiert werden, wobei die beste AF, d.h. mit bester berechneter Empfangsqualität, an die 1. Stelle sortiert wird, um bei einem erforderlichen Sprungversuch als aussichtsreichste AF zur Verfügung zu stehen,
- im Reg.-Off-Mode die Kennzeichnung Original- bzw. Nachbarsender ohne Berücksichtigung bleibt,
- im Reg.-On-Mode die Originalsender in den AFSTOR vor den Nachbarsendern einsortiert und damit bevorzugt werden,
- die Einmessungen der AF ständig oder aber in Abhängigkeit von bestimmten Qualitätsschwellen des gehörten Senders (was bei notwendigem AF-Wechsel die aktuelle Situationsbeschreibung bezogen auf die Senderlandschaft gewährleistet), bzw. zusätzlich immer bei Eintreffen neuer, unbekannter AF erfolgen.

Eine gezielte Schwankung der Periodizität gewährleistet dabei folgendes: Das menschliche Ohr hat die Eigenart, daß eigentlich normalerweise nicht wahrgenommene Störgeräusche dann bewußt als störend wahrgenommen bzw. empfunden werden, wenn diese Störgeräusche irgend eine Art Periodizität aufweisen. Eine Muteschaltung zur Einmessung von AF mit fester Periodizität könnte somit ungünstigstenfalls dazu führen, daß die eigentlich normalerweise nicht bewußt wahrgenommenen Stummschaltungen, das Muten, durch die Periodizität als Störung empfunden werden. Eine gezielte, insbesondere auch nicht periodische Änderung der Periodizität verhindert diesen Effekt wirksam.

Ist ein vorbestimmtes Verhältnis der Empfangsqualität des momentan gehörten bzw. eingestellten Senders zu der berechneten Empfangsqualität der AF im AFSTOR erfüllt, dann liegt eine Sprungbedingung vor und es erfolgt die Ablösung einer abgestimmten Empfangsfrequenz MF durch die beispielsweise an erster Stelle im AFSTOR stehende AF. Diese sogen. Bestsprungbedingung ist beispielsweise dann erfüllt, wenn die berechnete Empfangsqualität einen höheren Bewertungswert hat als die Empfangsqualität der Mutterfrequenz. Es kann zusätzlich eine Mindestverbesserung der Empfangsqualität vorbestimmt sein, d.h. der Bewertungswert der Empfangsqualität der AF im AFSTOR muß um mindesten einen vorbestimmten Betrag größer sein als der Bewertungswert der Empfangsqualität des momentan eingestellten Senders.

Die neue AF kommt nur in Frage (tritt an die Stelle der bisherigen MF) wenn die MF eine bestimmte Empfangsqualität unterschreitet und die Beste (1. AF) eine Empfangsverbesserung erwarten läßt.

Das bedeutet, daß die AF eine Mindestqualität aufweist, die davon abhängt, ob die AF bereits mit Erfolg PI-getestet wurde (Kennzeichnung im AFSTOR) und ob das Autoradio im REG.-Off-Mode betrieben wird. Im REG.-Off-Mode ist die Mindestqualifikation unabhängig von der Original-, bzw. Nachbarbereichskennzeichnung und wird lediglich durch die Kennzeichnung "schon PI-geprüft" beeinflußt. Hierbei benötigen AF, die schon erfolgreich PI-geprüft wurden, eine geringere Qualifikation, als diejenigen, die noch nicht eine solche Kennzeichnung haben. Insbesondere können bereits "PI-geprüfte" AF bei einem Sprungversuch ungemutet eingestellt, während AF, die diese Kennzeichnung nicht tragen, "gemutet" angesprungen werden.

Im Reg.-On-Mode werden die beschriebenen Qualifikationsbedingungen zunächst auf die "Originalsender" (sind im AFSTOR vor den Nachbarsendern einsortiert) angewandt. Sollte trotz schlechter Empfangsqualität der MF keine hinreichend gut bewertete Original-AF zur Verfügung stehen, so kann auch eine Nachbarbereichs-AF angesprungen werden, sofern diese eine Mindestqualifikation erreicht, die ein schnelles PI-Erkennen erwarten läßt. Diese Mindestqualifikation liegt allerdings höher als bei Original-AF. Bei einem Wechsel auf solche AF'en muß sich aber der PI-Code als identisch erweisen.

Die Mindestqualifikation für MF und AF sind durch programmierbare Schwellwerte für die oben erwähnten Parameter, welche die Empfangsqualität charakterisieren, also beispielsweise Feldstärke, Datenfehlerrate, Multipathempfang usw., in einem nichtflüchtigen Speicher veränderbar und auf verschiedene Situationen, ggf., wie oben erwähnt, Länderspezifisch und unter Berücksichtigung der Signalpfadqualität anpaßbar. Ein AF-Wechsel wird beispielsweise auch dann ausgeführt, wenn die MF die RDS-Empfangsqualitätsschwelle zwar nicht unterschreitet, aber eine erheblich besser bewertete AF im AFSTOR zur Verfügung steht, die aber im Falle des Reg.-On-Mode eine "Original"-Kennung tragen muß.

Davon abweichend sind in vorteilhafter Weise "Sonderbedingungen" für Bestsprünge bei Frequenzneueinstellungen (Stationstastenaufruf) oder bei extrem schlechten Empfangsverhältnissen für die MF vorgesehen. Nach einem Stationsaufruf oder einem Frequenzwechsel durch Suchlauf wird nicht nur eine AF, wie die o.g. erste AF im AFSTOR, geprüft, sondern eine Anzahl "n" mit Mindestqualität aus dem Pool der AF. Die Anzahl "n" ist programmierbar und wird nicht flüchtig abgelegt. Man nutzt hier verlängerte Mutezeiten aus, die bei Frequenzeinstellungen, z.B. Tastenbetätigungen, ohnehin auftreten und nicht stören weil sie vom Benutzer erwartet werden.

Während alle Standard-AF-Wechsel immer auf AF mit identischen PI erfolgen, wird auch bei Frequenzneueinstellungen im Reg.-On-Mode grundsätzlich eine AF mit identischem PI gesucht. Es werden aber auch, sofern keine entsprechende AF empfangbar ist, AF mit verwandten PI, als Abweichung im 2. Nibbel, zugelassen.

AF'en die z.Zt. mit Verboten oder Einschränkungen belegt sind werden bei Überschreiten einer Mindestbewertung, nach Stationsaufruf oder in Notsituationen (bei extrem schlechtem Empfang) wieder zugelassen. Durch programmierbare Steuereinträge in einem nichtflüchtigen Speicher wird entschieden, ob die AF gemäß ihrer früheren Einträge als "schon einmal erfolgreich PI geprüft" zuerst gemutet und geprüft oder direkt ungemutet und ohne erneute Prüfung des PI-Codes eingestellt werden darf.

Nach einem Stationsaufruf und der PI-Prüfung von "n"-AF werden alle anderen im Speicher befindlichen AF zunächst als "Nachbarsender" eingetragen. Geben sich diese AF mittels eines empfangenen RDS-Signals, beispielsweise bei Neuempfang der AF-Liste, wieder als Originalsender zu erkennen, wird der Eintrag sofort korrigiert und die AF entsprechend bevorzugt.

## Patentansprüche

1. Verfahren zum Ablegen und Sortieren von Alternativfrequenzen (AF) in einem Alternativfrequenzspeicher eines RDS-Rundfunkempfängers, wobei die Alternativfrequenzen (AF) sowohl einer Alternativfrequenz-Liste eines H RDS-Signals eines momentan eingestellten Rundfunksenders als auch aus einer langzeitgespeicherten Liste unter der Programmidentifikation (PI) des eingestellten Rundfunksenders als auch aus einem Landschaftsspeicher, der die Alternativfrequenz (AF) mit zum momentan eingestellten Rundfunksender identischer, d.h. gültiger Programmidentifikation (PI) enthält und die z.Zt. empfangbaren Frequenzen im FM-Band wiederspiegelt, entnommen werden, wobei zu jeder unter einer bestimmten Programmidentifikation (PI) gespeicherten Alternativfrequenz (AF) wenigstens ein zusätzliches Kennzeichen gespeichert wird, und wobei das oder die zusätzlichen Kennzeichen als Sortierkriterium der Alternativfrequenzen (AF) im Alternativfrequenzspeicher verwendet werden, **dadurch gekennzeichnet daß** jede Alternativfrequenz (AF) in einem vorbestimmten, variierenden Rhythmus durch zeitlich kurze, im wesentlichen nicht wahrnehmbare Messungen von Suchlauf-Stop-Signal, Feldstärke und Qualität neu bewertet wird und daß der Rhythmus in seiner Periodizität gezielt schwankt.

2. Verfahren nach Anspruch 1,
**dadurch gekennzeichnet, daß** das wenigstens eine zusätzliche Kennzeichen ein erstes zusätzliches Kennzeichen ist, welches angibt, ob die Alternativfrequenz (AF) zu einem Original- oder Nachbarbereichs-Sender gehört, und/oder ein zweites zusätzliches Kennzeichen ist, welches angibt, ob in der unmittelbaren Vergangenheit die programmidentifikation (PI) dieser Alternativfrequenz (AF) bestätigt wurde, und/oder ein drittes zusätzliches Kennzeichen ist, welches angibt, ob eine vorübergehend verbotene Alternativfrequenz (AF) für eine Neubewertung freigegeben ist, und/oder ein viertes zusätzliches Kennzeichen ist, welches angibt, wie stark bzw. mit welcher Qualität die Alternativfrequenz (AF) bei ihrer letzten Messung bewertet wurde, und/oder ein fünftes zusätzliches Kennzeichen ist, welches angibt, ob die AF derzeit als verbotene AF gekennzeichnet ist.

3. Verfahren nach Anspruch 1 oder 2,
**dadurch gekennzeichnet, daß** die Alternativfrequenzen (AF) zusätzlich aus aktuell in Suchläufen erkannten Alternativfrequenzen (AF) hinzugefügt werden.

4. Verfahren nach einem der vorhergehenden Ansprüche, **dadurch gekennzeichnet, daß**
die Alternativfrequenz (AF) gemäß allen ihren Meßwerten und zusätzlichen Kennzeichen sortiert werden, wobei die Alternativfrequenz (AF) mit der besten zu erwartenden Empfangsqualität an die erste Stelle sortiert wird, um bei einem erforderlichen Sprungversuch als aussichtsreichste Alternativfrequenz (AF) zur Verfügung zu stehen.

5. Verfahren nach einem der vorhergehenden Ansprüche,
**dadurch gekennzeichnet, daß**
dieses in einem REG.-Off-Mode ausgeführt wird, wobei die Kennzeichnung Original- bzw. Nachbarsender ohne Berücksichtigung bleibt.

6. Verfahren nach einem Ansprüche 1 bis 4,
**dadurch gekennzeichnet, daß**
dieses in einem REG.-On-Mode ausgeführt wird, wobei die Originalsender vor den Nachbarsendern einsortiert werden und damit bevorzugt werden.

7. Verfahren nach einem der vorhergehenden Ansprüche,
**dadurch gekennzeichnet, daß**
die Einmessung der Alternativfrequenzen (AF) ständig oder in Abhängigkeit von bestimmten Qualitätsschwellen des momentan eingestellten Rundfunksenders erfolgt.

8. Verfahren nach einem der vorhergehenden Ansprüche,
**dadurch gekennzeichnet, daß**
die Einmessung der Alternativfrequenz (AF) zusätzlich immer bei Eintreffen neuer, unbekannter Alternativfrequenzen (AF) erfolgt.

9. RDS-Rundfunkempfänger mit PLL-Oszillator und Alternativfrequenzspeicher (100), der zum Durchführen des Verfahrens nach einem der vorhergehenden Ansprüche ausgebildet ist.

10. RDS-Rundfunkempfänger nach Anspruch 9
**dadurch gekennzeichnet, daß**
der Alternativfrequenzspeicher für jede Alternativfrequenz wenigstens einen zusätzlichen Speicherplatz aufweist zum Speichern von einem ersten zusätzlichen Kennzeichen, welches angibt, ob die Alternativfrequenz (AF) zu einem Original- oder Nachbarbereichs-Sender gehört, und/oder einem zweiten zusätzlichen Kennzeichen, welches angibt, ob in der unmittelbaren Vergangenheit der Programmidentifikation (PI) diese Alternativfrequenz (AF) bestätigt wurde, und/oder einem dritten zusätzlichen Kennzeichen, welches angibt, ob eine vorübergehend verbotene Alternativfrequenz (AF) für eine Neubewertung freigegeben ist, und/oder einem vierten zusätzlichen Kennzeichen, welches angibt, wie stark bzw. mit welcher Qualität die Alternativfrequenz (AF) bei ihrer letzten Messung bewertet wurde, und/oder einem fünften zusätzlichen Kennzeichen, welches angibt, ob die AF derzeit als verbotene AF gekennzeichnet ist.

## Claims

1. Method for storing and sorting alternative frequencies (AF) in an alternative frequency memory of an RDS broadcast radio receiver, wherein
the alternative frequencies (AF) are taken both from an alternative frequency list for an RDS signal from a currently selected broadcast radio station and also from a lengthily stored list under the programme identifier (PI) of the selected broadcast radio station and also from a landscape memory which contains the alternative frequency (AF) with a programme identifier (PI) which is identical to that of the currently selected broadcast radio station, i.e. a valid programme identifier, and reflects the frequencies that can currently be received in the FM band, wherein at least one additional identification is stored for each alternative frequency (AF) stored under a particular programme identifier (PI), and wherein the additional identification(s) is/are used as a sorting criterion for the alternative frequencies (AF) in the alternative frequency memory, **characterized in that** each alternative frequency (AF) is reassessed in a predetermined, varying rhythm by brief, essentially imperceptible measurements for a search stop signal, field strength and quality and **in that** the periodicity of the rhythm fluctuates in a specific manner.

2. Method according to Claim 1,
**characterized in that** the at least one additional identification is a first additional identification, which indicates whether the alternative frequency (AF) belongs to an original station or adjacent-domain station, and/or is a second additional identification, which indicates whether the programme identifier (PI) of this alternative frequency (AF) has been confirmed in the immediate past, and/or is a third additional identification, which indicates whether a temporarily prohibited alternative frequency (AF) is cleared for reassessment, and/or is a fourth additional identification, which indicates the level or quality at which the alternative frequency (AF) was assessed during its last measurement, and/or is a fifth additional identification, which indicates whether the AF is currently denoted as a prohibited AF.

3. Method according to Claim 1 or 2,
**characterized in that** the alternative frequencies (AF) are additionally added from alternative frequencies (AF) that are currently detected in searches.

4. Method according to one of the preceding claims, **characterized in that**
the alternative frequencies (AF) are sorted on the basis of all of their measured values and additional identifications, wherein the alternative frequency (AF) having the best reception quality that is to be expected is sorted into the first position in order to be available as an alternative frequency (AF) having the greatest prospects when a hopping attempt is required.

5. Method according to one of the preceding claims, **characterized in that**
said method is performed in a REG. Off mode, wherein the original-station or adjacent-station identifier is disregarded.

6. Method according to one of Claims 1 to 4, **characterized in that**
said method is performed in a REG. On mode, wherein the original stations are graded ahead of the adjacent stations and are therefore preferred.

7. Method according to one of the preceding claims, **characterized in that**
the alternative frequencies (AF) are calibrated continuously or on the basis of particular quality thresholds for the currently selected broadcast radio station.

8. Method according to one of the preceding claims, **characterized in that**
the alternative frequencies (AF) are additionally calibrated whenever new, unknown alternative frequencies (AF) arrive.

9. RDS broadcast radio receiver having a PLL oscillator and an alternative frequency memory (100) which is designed to perform the method according to one of the preceding claims.

10. RDS broadcast radio receiver according to Claim 9, **characterized in that**
the alternative frequency memory has, for each alternative frequency, at least one additional memory location for storing a first additional identification, which indicates whether the alternative frequency (AF) belongs to an original station or adjacent-domain station, and/or a second additional identification, which indicates whether the programme identifier (PI) of this alternative frequency (AF) has been confirmed in the immediate past, and/or a third additional identification, which indicates whether a temporarily prohibited alternative frequency (AF) is cleared for reassessment, and/or a fourth additional identification, which indicates the level or quality at which the alternative frequency (AF) was assessed during its last measurement, and/or a fifth additional identification, which indicates whether the AF is currently denoted as a prohibited AF.

## Revendications

1. Procédé de placement et de tri de fréquences alternatives (AF) dans une mémoire à fréquences alternatives d'un récepteur radio RDS, dans lequel
les fréquences alternatives (AF) sont reprises à la fois dans une liste de fréquences alternatives d'un signal RDS d'un émetteur de diffusion radio réglé à chaque instant, dans une liste conservée en mémoire à long terme dans l'identification (PI) des programmes de l'émetteur de diffusion réglé ainsi que dans une mémoire de régions qui contient les fréquences alternatives (AF) qui présentent une identification de programme (PI) identique à celle de l'émetteur de diffusion réglée à chaque instant et donc valide et les fréquences de la bande FM qui peuvent être reçues temporairement,
au moins une caractéristique supplémentaire étant conservée en mémoire en plus de chaque fréquence alternative (AF) conservée en mémoire sous une identification de programme (PI) définie,
la ou les caractéristiques supplémentaires étant utilisées comme critères de tri des fréquences alternatives (AF) dans la mémoire à fréquences alternatives,
**caractérisé en ce que**
chaque fréquence alternative (AF) est évaluée de nouveau à un rythme variable prédéterminé par de courtes mesures, essentiellement non détectables, du signal d'arrêt de recherche, de l'intensité du champ et de la qualité, et
**en ce que** la périodicité du rythme varie de manière contrôlée.

2. Procédé selon la revendication 1, **caractérisé en ce que** la ou les caractéristiques supplémentaires sont une première caractéristique supplémentaire qui indique si la fréquence alternative (AF) fait partie d'un émetteur de la zone d'origine ou de la zone voisine, une deuxième caractéristique supplémentaire qui indique si l'identification de programme (PI) de cette fréquence alternative (AF) a été constatée dans le passé immédiat, une troisième caractéristique supplémentaire qui indique si une fréquence alternative (AF) précédemment interdite est libérée pour une nouvelle évaluation, une quatrième caractéristique supplémentaire qui indique l'intensité et/ou la qualité à laquelle la fréquence alternative (AF) a été évaluée lors de sa dernière mesure et/ou une cinquième caractéristique supplémentaire qui indique si l'AF a été caractérisée à ce moment comme AF interdite.

3. Procédé selon les revendications 1 ou 2, **caractérisé en ce que** des fréquences alternatives (AF) supplémentaires provenant de fréquences alternatives (AF) détectées dans des boucles de recherche en cours sont ajoutées.

4. Procédé selon l'une des revendications précédentes, **caractérisé en ce que** les fréquences alternatives (AF) sont triées en fonction de toutes leurs valeurs de mesure et de caractéristiques supplémentaires, la fréquence alternative (AF) qui présente la meilleure qualité de réception que l'on puisse attendre étant classée au premier emplacement pour rester disponible comme fréquence alternative (AF) la plus visible au cas où un essai de saut est nécessaire.

5. Procédé selon l'une des revendications précédentes, **caractérisé en ce qu'**il est exécuté en mode REG.-Off, la caractérisation d'émetteur d'origine ou voisin n'étant pas prise en compte.

6. Procédé selon l'une des revendications 1 à 4, **caractérisé en ce qu'**il est exécuté en mode REG.-On, les émetteurs d'origine étant sélectionnés avant les émetteurs voisins et ainsi préférés.

7. Procédé selon l'une des revendications 1 à 4, **caractérisé en ce que** la mesure des fréquences alternatives (AF) s'effectue en permanence ou en fonction de seuils de qualité définis de l'émetteur de diffusion réglé à cet instant.

8. Procédé selon l'une des revendications 1 à 4, **caractérisé en ce que** la mesure des fréquences alternatives (AF) s'effectue de plus toujours lors de l'entrée de nouvelles fréquences alternatives (AF) inconnues.

9. Récepteur radio RDS doté d'un oscillateur PLL et d'une mémoire (100) à fréquences alternatives, configuré en vue de mettre en oeuvre le procédé selon l'une des revendications précédentes.

10. Récepteur radio RDS selon la revendication 9, **caractérisé en ce que** pour chaque fréquence alternative, la mémoire à fréquences alternatives présente au moins un emplacement supplémentaire de mémoire qui conserve une première caractéristique supplémentaire qui indique si la fréquence alternative (AF) fait partie d'un émetteur de la zone d'origine ou de la zone voisine, une deuxième caractéristique supplémentaire qui indique si l'identification de programme (PI) de cette fréquence alternative (AF) a été constatée dans le passé immédiat, une troisième caractéristique supplémentaire qui indique si une fréquence alternative (AF) précédemment interdite est libérée pour une nouvelle évaluation, une quatrième caractéristique supplémentaire qui indique l'intensité et/ou la qualité à laquelle la fréquence alternative (AF) a été évaluée lors de sa dernière mesure et/ou une cinquième caractéristique supplémentaire qui indique si l'AF a été caractérisée à ce moment comme AF interdite.
